# EUROPEAN PATENT APPLICATION

(11) **EP 4 697 130 A1**
(43) Date of publication of application: **18.02.2026**
(21) Application number: 24807503.8
(22) Date of filing: 13.05.2024
(51) Int. Cl.: G06F 1/16, C25D 11/02, B24C 1/10, C23C 4/10, C23C 4/12

(54) **ELECTRONIC DEVICE COMPRISING HOUSING**

(30) Priority: 12.05.2023 KR 20230061961; 30.05.2023 KR 20230069467
(71) Applicant: Samsung Electronics Co., Ltd., Suwon-si, Gyeonggi-do 16677 (KR)
(72) Inventor: HWANG, Hyunjin, Suwon-si, Gyeonggi-do 16677 (KR); KIM, Taejeong, Suwon-si, Gyeonggi-do 16677 (KR); SONG, Kyunghwan, Suwon-si, Gyeonggi-do 16677 (KR); JANG, Hansoo, Suwon-si, Gyeonggi-do 16677 (KR); HEO, Sungyoung, Suwon-si, Gyeonggi-do 16677 (KR); PARK, Byounggyu, Suwon-si, Gyeonggi-do 16677 (KR); CHOI, Hyunsuk, Suwon-si, Gyeonggi-do 16677 (KR)
(74) Representative: HGF
(86) International application number: PCT/KR2024/006454
(87) International publication number: WO 2024/237632

(57) **Abstract**

The electronic device according to one embodiment of the present invention comprises a housing, wherein the housing can include an outer surface having an irregular surface shape. The outer surface may include a plurality of recessions having an irregular shape, and a plurality of atypical bar patterns including a plurality of mirror surfaces positioned to be adjacent to the plurality of recessions and formed horizontally with respect to each other.

## Description

### [Technical Field]

Various embodiments of the disclosure relate to an electronic device including a housing.

### [Background Art]

As electronic devices become more closely integrated into daily life and their fields of use continue to extend, not only the functionality but also the aesthetic beauty of the appearance of electronic devices is becoming important. In order to enhance the aesthetic appeal of products and emphasize design differentiation, efforts to implement new visual or tactile textures on appearance components of electronic devices, e.g., housings, are continuing in various ways. An electronic device may include a housing including a front surface, a rear surface, and a side surface surrounding a space between the front surface and the rear surface. Alternatively, an electronic device may include a housing having a structure forming some of the front surface, rear surface, and side surfaces.

Meanwhile, a housing may typically have a uniform surface shape. A uniform surface shape may only exhibit regular texture or color, making it difficult to express more diverse textures or colors, so there is a need to enhance the optical aesthetic appeal of the housing appearance through a new surface shape. Further, according to an etching process, it is difficult to implement irregularities beyond a predetermined depth due to reactivity with metal, which makes it difficult to perform multiple coloring or mirror-finishing on irregularities, so there is a need for a new housing and its manufacturing method to implement an appearance including excellent mirror surfaces.

### [Disclosure of Invention]

### [Solution to Problems]

An embodiment of the disclosure may provide an electronic device including a housing.

An embodiment of the disclosure may provide a housing having irregular texture and/or color.

An embodiment of the disclosure may provide a housing including a plurality of irregularities having mirror surfaces by forming irregularities having a predetermined depth to enable mirror-finishing and forming mirror surfaces on the irregularities.

An electronic device according to an aspect of the disclosure may include a housing, and the housing may include an outer surface including an irregular surface shape. The outer surface may include a plurality of recessions having irregular shapes, and a plurality of atypical rod patterns including a plurality of mirror surfaces positioned adjacent to the plurality of recessions and formed horizontally with respect to each other.

A housing according to an aspect of the disclosure may include an outer surface including an irregular surface shape, and the outer surface may include a plurality of recessions having irregular shapes, and a plurality of atypical rod patterns including a plurality of mirror surfaces positioned adjacent to the plurality of recessions and formed horizontally with respect to each other.

According to an embodiment of the disclosure, an irregular glossy appearance may be realized using mirror surfaces irregularly formed on a housing.

According to an embodiment, by having an outer surface with roughness in a specific numerical range, irritation to the skin in case of being gripped by a user may be decreased, and grip feeling may be enhanced by increasing the contact area between the skin and the housing.

According to an embodiment, impact resistance from external impacts may also be enhanced by the plurality of atypical rod patterns.

Effects achievable in example embodiments of the disclosure are not limited to the above-mentioned effects, but other effects not mentioned may be apparently derived and understood by one of ordinary skill in the art to which example embodiments of the disclosure pertain, from the following description. In other words, unintended effects in practicing embodiments of the disclosure may also be derived by one of ordinary skill in the art from example embodiments of the disclosure.

### [Brief Description of Drawings]

FIG. 1 is a view illustrating an electronic device in a network environment according to an embodiment.
FIG. 2A is a front perspective view illustrating an electronic device according to various embodiments of the disclosure.
FIG. 2B is a rear perspective view illustrating an electronic device according to various embodiments of the disclosure.
FIG. 3 is a cross-sectional view schematically illustrating a housing according to an embodiment of the disclosure.
FIG. 4 is a cross-sectional view illustrating the region A of the housing illustrated in FIG. 3 according to an embodiment of the disclosure.
FIG. 5 is a flowchart illustrating a manufacturing method of a housing according to an embodiment of the disclosure.
FIG. 6 is a diagram illustratively illustrating a cross-section of a housing according to each step of the manufacturing method of FIG. 5.
FIGS. 7A and 7B are views for an experimental example in which the average roughness and average maximum height of profile of a housing change before and after mirror-finishing.
FIG. 8 is a cross-sectional view illustrating the region A of the housing illustrated in FIG. 3 according to an embodiment of the disclosure.
FIG. 9 is a schematic diagram illustrating a coloring process according to an embodiment of the disclosure.
FIG. 10 is a cross-sectional view illustrating the region A of the housing illustrated in FIG. 3 according to an embodiment of the disclosure.

Reference may be made to the accompanying drawings in the following description, and variable examples that may be practiced are shown as examples within the drawings. Other examples may be utilized and structural changes may be made without departing from the scope of the various examples.

### [Mode for the Invention]

Embodiments of the present invention are now described with reference to the accompanying drawings in such a detailed manner as to be easily practiced by one of ordinary skill in the art. However, the disclosure may be implemented in other various forms and is not limited to the embodiments set forth herein. The same or similar reference denotations may be used to refer to the same or similar elements throughout the specification and the drawings. Further, for clarity and brevity, no description is made of well-known functions and configurations in the drawings and relevant descriptions.

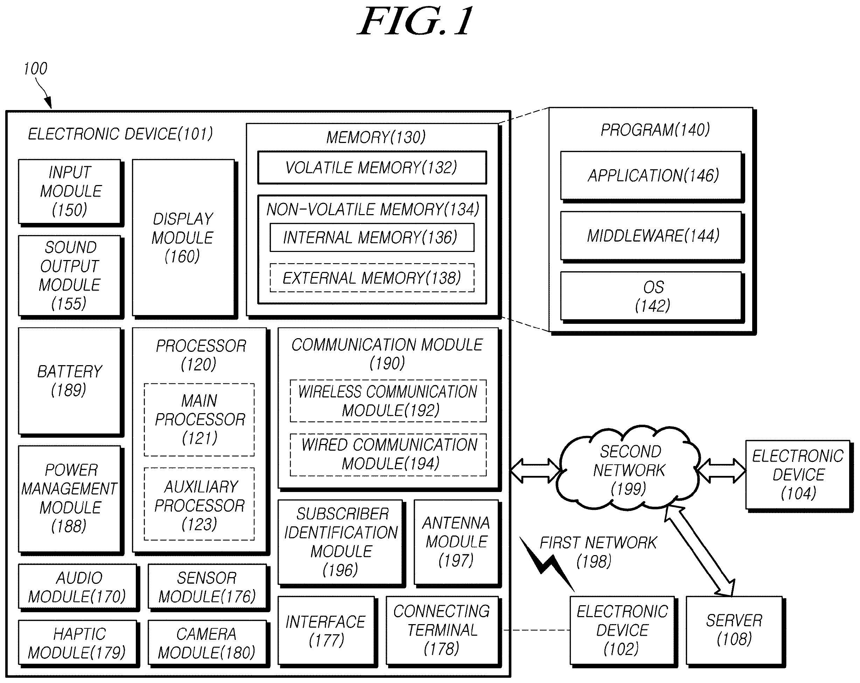

FIG. 1 is a block diagram illustrating an electronic device 101 in a network environment 100 according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network).According to an embodiment, the electronic device 101 may communicate with the electronic device 104 via the server 108.According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197.In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software(e.g., the program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134.According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, in case that the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application).According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101.The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101.The input module 150 may include, for example, a microphone, a mouse, a keyboard, keys (e.g., buttons), or a digital pen (e.g., a stylus pen).

The sound output module 155 may output sound signals to the outside of the electronic device 101.The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101.The display module 160 may include, for example, a display, a hologram device, or a projector and control circuitry to control a corresponding one of the display, hologram device, and projector. According to an embodiment, the display module 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102)directly (e.g., wiredly) or wirelessly coupled with the electronic device 101.

The sensor module 176 may detect an operation state (e.g., power or temperature) of the electronic device 101 or an external environmental state (e.g., the user's state), and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102).According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101.According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wiredly) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module).A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)).These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmittedor received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108.For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101.The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

Hereinafter, the external appearance and internal configuration of an electronic device according to various embodiments of the disclosure are described. In the disclosure, the external appearance and internal configuration of the electronic device may be described with reference to a plurality of directions. The plurality of directions include a first direction (e.g., +X-axis direction), a second direction (e.g., +Y-axis direction), and a third direction (e.g., +Z-axis direction). Further, the plurality of directions may further include a fourth direction (e.g., -X-axis direction), a fifth direction (e.g., -Y-axis direction), and a sixth direction (e.g., -Z-axis direction) respectively opposite to the first direction, the second direction, and the third direction. Meanwhile, in the disclosure, a vertical direction may include a Z-axis direction (or -Z-axis direction), and a horizontal direction may include an X-axis direction (or -X-axis direction) and a Y-axis direction (or -Y-axis direction).

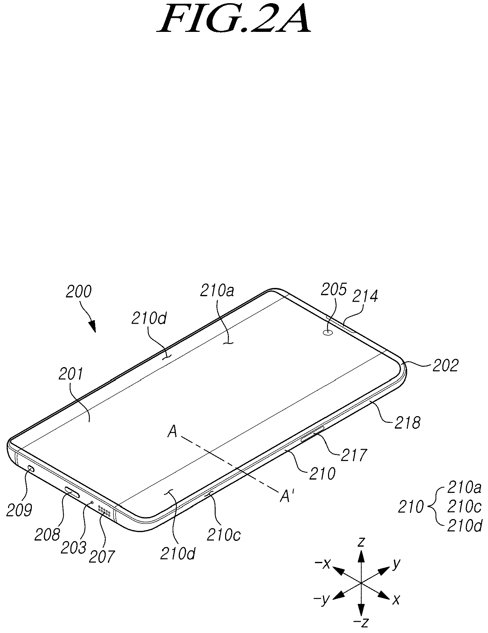

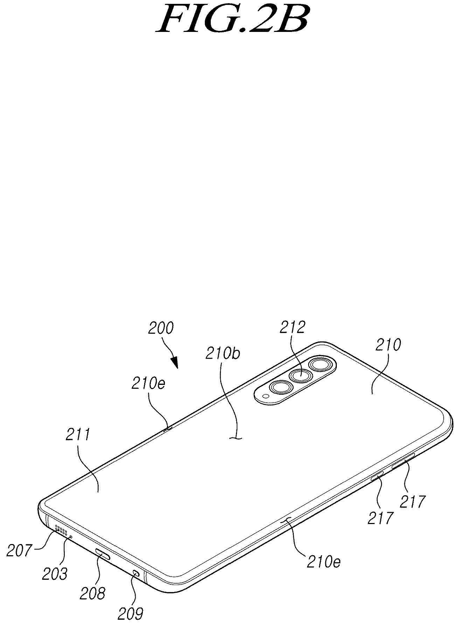

FIG. 2A is a front perspective view illustrating an electronic device according to various embodiments of the disclosure. FIG. 2B is a rear perspective view illustrating an electronic device according to various embodiments of the disclosure;

Referring to FIGS. 2A and 2B, an electronic device 200 includes a housing 210 including a front surface 210a, a rear surface 210b, and a side surface 210c surrounding a space between the front surface 210a and the rear surface 210b. The housing 210 may refer to a structure that forms some of the front surface 210a, the rear surface 210b, and the side surface 210c.

At least a portion of the front surface 210a may be formed by a substantially transparent front plate 202 (e.g., a glass plate, polymer plate, or cover glass including various coating layers). The front plate 202 may be formed of 2D glass or 2.5D glass, but is not limited thereto.

The rear surface 210b may be formed by a rear plate 211. The rear plate 211 may be formed of, e.g., glass, ceramic, polymer, metal (e.g., aluminum, stainless steel, or magnesium), or a combination of at least two of the above-described materials.

The side surface 210c may be coupled to the front plate 202 and the rear plate 211 to be formed by the side surface 210c bezel structure 218 (or a "side surface 210c member") including a metal and/or a polymer. At least one of the side bezel structure 218, the front plate 202, and/or the rear plate 211 may be integrally formed. For example, the side bezel structure 218 and the front plate 202, the side bezel structure 218 and the rear plate 211, or the side bezel structure 218 and the front and rear plates 202 and 211 may be integrally formed with each other. The side bezel structure 218 integrally formed may include glass, a metal material such as aluminum, or ceramic, and the other components (e.g., the front plate 202 and/or the rear plate 211) integrally formed may include substantially the same material.

The front plate 202 may include two first edge areas 210d bent from the front surface 210a toward the rear plate 211 and extending seamlessly at two opposite ends of a long edge of the front plate 202. The rear plate 211 may include two second edge areas 210e bent from the rear surface 210b toward the front plate 202 and extending seamlessly at two opposite ends of the long edge. The front plate 202 (or the rear plate 211) may include only one of the first edge areas 210d (or the second edge areas 210e). At least some of the first edge areas 210d or the second edge areas 210e may not be included. In case that at least one of the first edge areas 210d or the second edge areas 210e is not included, a process for processing the first edge areas 210d or the second edge areas 210e may be omitted, thereby reducing production costs.

In case of being viewed from one side of the electronic device 200, the side bezel structure 218 may have a first thickness (or width) on a side surface in which the first edge areas 210d or the second edge areas 210e are not included, and may have a second thickness smaller than the first thickness on a side surface 210c including the first edge areas 210d or the second edge areas 210e.

The electronic device 200 may include at least one of a display 201 (e.g., including the display module 160 of FIG. 1), audio modules 203, 207, and 214 (e.g., including the audio module 170 of FIG. 1), a sensor module (e.g., including the sensor module 176 of FIG. 1), camera modules 205 and 212 (e.g., including the camera module 180 of FIG. 1), an input device 217 (e.g., including the input module 150 of FIG. 1), and/or connector holes 208 and 209 (e.g., including the connecting terminal 178 of FIG. 1). The electronic device 200 may omit at least one of the components or may further include other components.

The display 201 may be visually exposed through at least a portion of the front plate 202. For example, at least a portion of the display 201 may be exposed through the front surface 210a and/or the first edge areas 210d of the front plate 202. The edge of the display 201 may be formed to be substantially the same as the adjacent outer shape of the front plate 202. In order to increase the area in which the display 201 is visually exposed, the gap between the outer periphery of the display 201 and the outer periphery of the front plate 202 may be formed to be substantially the same.

The surface (or the front plate 202) of the housing 210 may include a display area. The display area may be specified as the display 201 is visually exposed. The display area may include a front surface 210a and first edge areas 210d.

One or more hole areas may be included in a portion of the display area of the display 201, and the one or more hole areas may include at least one of a sensor area and/or a camera area. One or more sensors may be disposed in the sensor area, and one or more cameras 205 may be disposed in the camera area. As the camera area is included as at least a portion of the display area, the area allocated to place and install the camera 205 is reduced, so that the display area may be designed to be larger. Further, as the sensor area is included as at least a portion of the display area, the area allocated to place and install the sensor is reduced, so that the display area may be designed to be larger. As such, including a camera area and/or a sensor area as at least a portion of the display area is also referred to as a so-called under panel camera or under panel sensor technology.

The display 201 may include a touch sensing unit for sensing a touch input. The touch sensing unit may include, but is not limited to, a touch sensing circuit unit, a pressure sensor, and/or a digitizer.

The audio modules 203, 207, and 214 may include, e.g., a microphone hole 203 and speaker holes 207 and 214. One or more microphones for obtaining an external sound may be disposed in the microphone hole 203. A microphone array for detecting a sound and a direction in which the sound is generated or incident may be disposed in the microphone hole 203. The speaker holes 207 and 214 may include an external speaker hole 207 and/or a call receiver hole 214. The speaker hole 207 and the receiver hole 214 may be formed as one hole or individually independent holes. One or more speakers for emitting sound to the outside may be disposed in the speaker hole 207. The audio modules 203, 207, and 214 are not limited to the above-described structure and/or configuration, and according to the structure of the electronic device 200, only some of the audio modules 203, 207, and 214 may be provided, or a new audio module may be added.

The camera modules 205 and 212 may include at least one of a front camera module 205 and/or a rear camera module 212. The front camera module 205 may be disposed on the front surface 210a of the electronic device 200, and the rear camera module 212 may be disposed on the rear surface 210b of the electronic device 200. The camera modules 205 and 212 may include one or more lenses, an image sensor, and/or an image signal processor.

The front camera module 205 may be disposed in a hole area included as at least a portion of the display area, but is not limited thereto and may be disposed outside the display area.

The rear camera module 212 may include various types of cameras. For example, it may be understood that the rear camera module 212 includes heterogeneous camera(s) such as an infrared camera, a telephoto camera, and/or a wide-angle camera. The rear camera module 212 may further include a flash in some cases. The flash may include a light emitting device, such as a light emitting diode (LED) or a xenon lamp.

The rear camera module 212 may include two or more cameras having different specifications. For example, the rear camera module 212 may include a wide-angle camera and/or a telephoto camera. For example, the rear camera module 212 may include a wide-angle camera, an ultra-wide-angle camera, and/or a telephoto camera. For example, the rear camera module 212 may further include an infrared (IR) camera (e.g., a time of flight (TOF) camera or a structured optical camera). The IR camera may operate as at least a portion of the sensor module. For example, the TOF camera may be operated as at least a portion of a sensor module for detecting a distance to a subject. The two or more cameras included in the rear camera module 212 may be disposed close to each other. Although not limited thereto, the two or more cameras may be arranged in a line or may be arranged to be spaced apart from each other at equal intervals.

The input device 217 may be disposed on at least one side surface of the housing 210. The input device 217 disposed on at least one side surface of the housing 210 may be implemented in the form of a hard key. Meanwhile, the input device 217 may be implemented in the form of a soft key on the display. The input device 217 may include a sensor module disposed on the rear surface 210b of the housing 210.

The connector holes 208 and 209 may include a first connector hole 208 for receiving a connector (e.g., a USB connector) for transmitting/receiving power and/or data to/from an external electronic device and/or a second connector hole 209 (e.g., an earphone jack) for transmitting/receiving audio signals to/from an external electronic device.

An electronic device according to an embodiment of the disclosure may be a foldable electronic device, a slidable electronic device, or a rollable electronic device. A foldable electronic device may include two housings that may face each other. A slidable electronic device or a rollable electronic device may include a main housing and a sub housing that may be operatively moved or bent to the outside or inside of the main housing. In other words, an electronic device according to an embodiment of the disclosure is not limited to a bar-type electronic device and may be realized in various types of form factors.

A housing of an electronic device according to an embodiment of the disclosure may include a plurality of atypical rod patterns. The plurality of atypical rod patterns may be formed across the outer surface of the housing. The plurality of atypical rod patterns may each have different or similar shapes. The plurality of atypical rod patterns do not have substantially the same shape as other adjacent rod patterns, and accordingly, irregularly shaped rod patterns may be positioned on the outer surface of the housing.

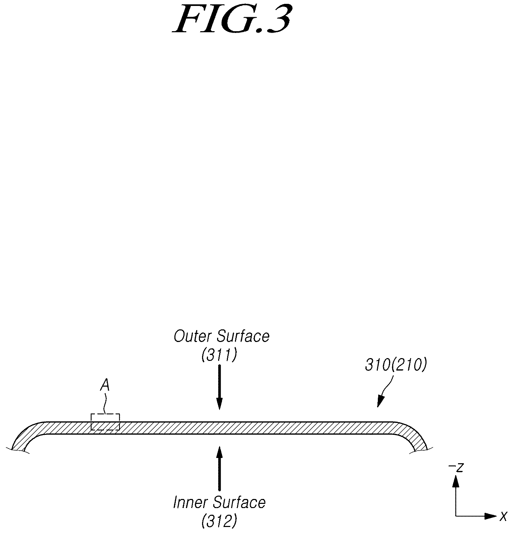

FIG. 3 is a cross-sectional view schematically illustrating a housing according to an embodiment of the disclosure.

In an embodiment, an electronic device (e.g., the electronic device 101 of FIG. 1, the electronic device 200 of FIGS. 2A and 2B) may include a housing 310. The housing 310 (e.g., the housing 210 of FIGS. 2A and 2B) may include an outer surface 311 exposed to the outside and an inner surface 312 concealed to the inside. The inner surface 312 of the housing 310 is coupled with other components, and the outer surface 311 is exposed to an external environment and may be observed or gripped by a user.

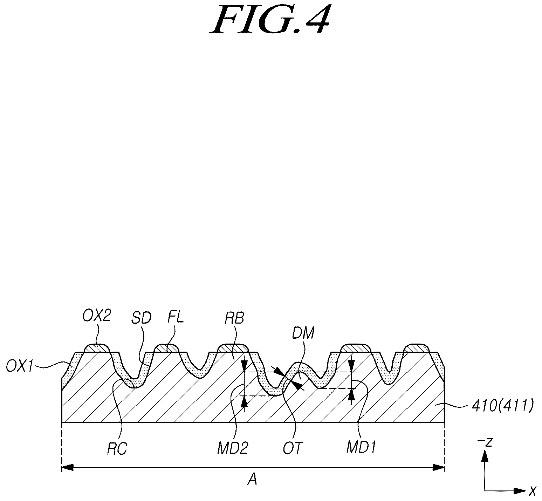

FIG. 4 is a cross-sectional view illustrating the region A of the housing illustrated in FIG. 3 according to an embodiment of the disclosure.

In an embodiment, a housing 410 may include an outer surface 411 including an irregular surface shape. The outer surface 411 may include a plurality of recessions RC having irregular shapes, and a plurality of mirror surfaces FL positioned adjacent to the plurality of recessions RC and formed vertically with respect to each other. Further, the outer surface 411 may include one or more irregularities DM, but the irregularities DM may not be included in the outer surface 411.

In an embodiment, the plurality of mirror surfaces FL may be included in an atypical rod pattern RB. The housing 410 may include the atypical rod pattern RB on the outer surface 411. An upper surface of the rod pattern may be formed as a mirror surface FL. Accordingly, the upper surface of the rod pattern may be formed flat, and in the disclosure, the upper surface formed flat as such may be referred to as a mirror surface FL. Further, a side surface SD of the atypical rod pattern RB may have an irregular shape. The side surfaces SD of the plurality of atypical rod patterns RB may have irregular shapes that do not at least partially coincide. Specifically, the side surfaces SD of each of the plurality of atypical rod patterns RB may be formed to have different curvature patterns, radii of curvature, and/or curvature trends from each other.

In an embodiment, a recession RC may be formed between the plurality of atypical rod patterns RB. The plurality of atypical rod patterns RB may be positioned separated by a predetermined distance, and a recession RC of a predetermined depth may be formed therebetween. In an embodiment, the depths of the plurality of recessions RC may be substantially the same, similar, or different from each other.

In an embodiment, a first oxide layer OX1 may be disposed on (e.g., in the -Z-axis direction) the plurality of recessions RC. The housing 410 may include at least one of metal or alloy as a material. The housing 410 may include, e.g., aluminum or aluminum alloy. As the housing 410 is subjected to oxidation treatment, a first oxide layer OX1 may be formed on the side surface SD of the atypical rod pattern RB. The first oxide layer OX1 formed on the side surface SD of the atypical rod pattern RB may be continuously formed along the recession RC of the housing 410.

In an embodiment, a second oxide layer OX2 may be disposed on the plurality of mirror surfaces FL. The housing 410 may include at least one of metal or alloy as a material. The housing 410 may include, e.g., aluminum or aluminum alloy. As the housing 410 is subjected to oxidation treatment, a second oxide layer OX2 may be formed on the mirror surface FL of the atypical rod pattern RB.

In an embodiment, the first oxide layer OX1 and the second oxide layer OX2 may be formed in different oxidation treatment steps. For example, the first oxide layer OX1 may be formed through a first oxidation treatment, and the second oxide layer OX2 may be formed through a second oxidation treatment.

The first oxidation treatment and the second oxidation treatment may be temporally separated. For example, the second oxidation treatment may be performed after performing the first oxidation treatment, or the first oxidation treatment may be performed after performing the second oxidation treatment. In case that the first oxidation treatment is performed first, the first oxide layer OX1 formed on the side surface SD of the atypical rod pattern RB may be formed before the second oxide layer OX2 formed on the mirror surface FL. In case that the second oxidation treatment is performed first, the first oxide layer OX1 formed on the side surface SD of the atypical rod pattern RB may be formed after the second oxide layer OX2 formed on the mirror surface FL.

In an embodiment, the mirror surface FL may be formed through mirror-finishing the plurality of irregularities DM, and by the mirror-finishing, the plurality of irregularities DM may be processed into a plurality of atypical rod patterns RB. The atypical rod pattern RB may include a mirror surface FL on the upper portion, unlike the plurality of irregularities DM. Since the second oxide layer OX2 is formed on the mirror surface FL of the atypical rod pattern RB, the second oxidation treatment may be performed after the mirror-finishing.

In an embodiment, the first oxidation treatment may be performed with priority over the second oxidation treatment, and in this case, the mirror-finishing may be performed on the plurality of irregularities DM on which the first oxide layer OX1 is formed. Accordingly, the mirror-finishing may remove at least a portion of the upper portions of the plurality of irregularities DM together with the first oxide layer OX1, and the plurality of irregularities DM that were covered by the first oxide layer OX1 may be revealed by the mirror-finishing. The surface revealed by the mirror-finishing may be a mirror surface FL. Thereafter, a second oxide layer OX2 may be formed on the mirror surface FL by the second oxidation treatment.

In an embodiment, the first oxidation treatment may also be performed with lower priority than the second oxidation treatment. In this case, the mirror-finishing may be performed on the plurality of irregularities DM before forming the first oxide layer OX1. In other words, in this case, the first oxidation treatment and the second oxidation treatment may be performed on the plurality of atypical rod patterns RB formed from at least a portion of the plurality of irregularities DM. The first oxide layer OX1 and the second oxide layer OX2 may be formed by the first oxidation treatment and the second oxidation treatment, respectively, and in this case, the regions where the first oxide layer OX1 and the second oxide layer OX2 are formed may be distinguished by masking.

The first oxide layer OX1 and the second oxide layer OX2 may be formed so as not to overlap each other. The first oxide layer OX1 and the second oxide layer OX2 may be formed separately from each other. The first oxide layer OX1 may be formed on the side surface SD and/or recession RC of the atypical rod pattern RB, and the second oxide layer OX2 may be formed on the mirror surface FL of the atypical rod pattern RB.

In an embodiment, the first oxide layer OX1 and the second oxide layer OX2 may be formed with different thicknesses from each other. For example, the thickness of the second oxide layer OX2 may be formed thinner than the thickness of the first oxide layer OX1, and thus the mirror surface FL disposed below the second oxide layer OX2 may shine more. Further, by differentiating the thicknesses of the first oxide layer OX1 and the second oxide layer OX2, the side surface SD of the atypical rod pattern RB positioned below the first oxide layer OX1 and the mirror surfaces FL of the atypical rod pattern RB positioned below the second oxide layer OX2 may have different colors.

In an embodiment, the second oxide layer OX2 may be surrounded by the first oxide layer OX1 in case that the surface shape is viewed vertically. The second oxide layer OX2 may be formed on the mirror surface FL created by processing the plurality of irregularities DM on which the first oxide layer OX1 is formed, and the second oxide layer OX2 may be surrounded by the first oxide layer OX1. Specifically, the first oxide layer OX1 and the second oxide layer OX2 may be formed on the plurality of atypical rod patterns RB disposed on the outer surface 411 of the housing 410, and the second oxide layer OX2 may be formed on the mirror surface FL created by removing a portion of the first oxide layer OX1 and the plurality of irregularities DM through processing, so that the second oxide layer OX2 may be surrounded by the first oxide layer OX1.

In an embodiment, at least one of the first oxide layer OX1 and/or the second oxide layer OX2 may be formed as a porous oxide film. Specifically, the porous oxide film forming at least one of the first oxide layer OX1 and/or the second oxide layer OX2 may be formed by the first oxidation treatment and/or the second oxidation treatment, and the first oxidation treatment and/or the second oxidation treatment may include an anodizing process. The first oxide layer OX1 and/or the second oxide layer OX2 may be formed to be porous through a pretreatment process. A coloring process and a sealing process may be performed on the first oxide layer OX1 and/or the second oxide layer OX2 that have undergone the pretreatment process, and accordingly, the first oxide layer OX1 and/or the second oxide layer OX2 may have colors according to their respective coloring processes.

In an embodiment, at least one of the first oxide layer OX1 and/or the second oxide layer OX2 may be colored to exhibit a predetermined color. A coloring process may be performed on the first oxide layer OX1 and/or the second oxide layer OX2. By the coloring process, a colored layer(s) may be formed on at least one of the first oxide layer OX1 and/or the second oxide layer OX2. A first colored layer may be formed on the first oxide layer OX1, and a second colored layer may be formed on the second oxide layer OX2. The first colored layer and the second colored layer may have different colors from each other. Meanwhile, the first colored layer may be formed by changing at least a portion of the first oxide layer OX1, and the second colored layer may be formed by changing at least a portion of the second oxide layer OX2. Based on the properties of the second oxide layer OX2 (or the second colored layer), the mirror surface below the second colored layer may be either glossy or matte.

In an embodiment, the plurality of mirror surfaces FL may include a mirror surface #1 and a mirror surface #2 disposed around the mirror surface #1. The mirror surface #1 and the mirror surface #2 may have continuous slope change values with respect to each other. The mirror surface #1 and the mirror surface #2 may be mirror surfaces of any atypical rod patterns RB positioned adjacent to each other. In an embodiment, the mirror surface #1 and the mirror surface #2 may be formed to have a constant slope along a horizontal direction. In an example, the constant slope may include 0 degrees or 180 degrees parallel to the horizontal direction, or a predetermined acute angle.

In an embodiment, the plurality of recessions RC and the plurality of mirror surfaces FL may be formed by mirror-finishing the plurality of irregularities DM. The mirror-finishing may include physical processing (e.g., polishing processing) such as cutting processing or grinding processing. Chemical processing may also be applied, but chemical processing may have a small etching amount and may be difficult to implement the mirror surface FL due to the form of irregular curves. A tool for mirror-finishing may include, but is not limited to, about 60% polyurethane, about 40% silicon carbide, and a small amount of silicon oxide, and the conditions may include at least one of rough cutting (RPM, 4000, feed, 1000mm/min, depth of cut, 0.1, Mesh#600), or finish cutting (RPM, 4000, feed, 1000 mm/min, depth of cut, 0.1, Mesh#2000).

In an embodiment, the plurality of irregularities DM may be formed through a blasting method using spherical or grit-shaped media so that the plurality of irregularities DM have an irregular surface shape. To form irregular irregularities DM, according to an embodiment, a blasting method may be performed. The blasting method may form irregularities DM of various shapes according to the type of media. According to an embodiment, the media for forming the plurality of irregularities DM may have a shape such as a sphere, grit having a size of at least 0.25 mm, or 0.25 to 2.0 mm. The media may include materials such as metal or chromium. The media may also include various materials such as stainless steel, zirconia, emery, or combinations thereof. In an embodiment, the depth of the plurality of irregularities DM formed by the media may have a dimension greater than the thickness of the first oxide layer OX1.

In an embodiment, the first oxide layer OX1 may be formed on the plurality of irregularities DM, and the second oxide layer OX2 may be formed on the plurality of mirror surfaces FL after the mirror-finishing of the plurality of irregularities DM. In case that the first oxidation treatment is performed prior to the mirror-finishing, the mirror-finishing may be performed on at least a portion of the plurality of irregularities DM on which the first oxide layer OX1 is formed on the upper portion. Accordingly, at least a portion of the plurality of irregularities DM and at least a portion of the first oxide layer OX1 may be removed, and the mirror surfaces FL of at least a portion of the plurality of irregularities DM may be formed and revealed. Thereafter, the second oxide layer OX2 may be formed on the mirror surface FL by the second oxidation treatment of the formed mirror surface FL.

In an embodiment, the depths MD1 and MD2 of the irregularities DM may be formed to be equal to or greater than the thickness OT of the first oxide layer OX1. In case that the depths MD1 and MD2 of the irregularities DM are smaller than the thickness OT of the first oxide layer OX1, it may not be possible to form a surface for forming the second oxide layer OX2. The depths MD1 and MD2 of the irregularities DM may vary according to the shape of the irregularities DM. Accordingly, the thickness OT of the first oxide layer OX1 may be formed equal to or smaller than the smallest value among the depths MD1 and MD2 of each of the plurality of irregularities DM. Alternatively, the thickness OT of the first oxide layer OX1 may be formed equal to or smaller than the average of the depths MD1 and MD2 of the plurality of irregularities DM.

In an embodiment, an arithmetic mean roughness (Ra) of the plurality of irregularities DM may be about 6.2 to 6.4 um, or about 6.5 to 6.6 um, and an average maximum height of profile (Rz) of the plurality of irregularities DM may be about 69.8 to 82.5 um, or about 86.7 to 90.1 um.

According to an embodiment, through mirror-finishing, an arithmetic mean roughness (Ra) of the atypical rod pattern RB including the plurality of mirror surfaces FL may be about 2.9 to 4.0 um, or about 1.5 to 3.0 um, and an average maximum height of profile of the atypical rod pattern RB including the plurality of mirror surfaces FL may be about 36.7 to 60.6 um or about 37.0 to 77.2 um.

According to an embodiment, an arithmetic mean height (Sa) of the atypical rod pattern RB including the plurality of mirror surfaces FL may be any one of about 5.00 to 10.00 um, about 5.49 to 9.06 um, about 5.49 to 7.79 um, or about 7.79 to 9.06 um. According to an embodiment, a maximum height of the surface (Sz) of the atypical rod pattern RB may be any one of about 73 to 104 um, about 74 to 104 um, about 74 to 103 um, about 74 to 100 um, or about 100 to 103 um.

According to an embodiment, a peak count (Spc) of the atypical rod pattern RB including the plurality of mirror surfaces FL may be any one of about 1836 to 3111 mm⁻¹, about 1836 to 1977 mm⁻¹, or about 1977 to 3111 mm⁻¹.

According to an embodiment, a developed interfacial area ratio (Sdr) of the atypical rod pattern RB including the plurality of mirror surfaces FL may be any one of about 0.36 to 1.25, about 0.36 to 0.44, or about 0.44 to 1.25.

According to an embodiment, a texture aspect ratio (Str) of the atypical rod pattern RB including the plurality of mirror surfaces FL may be any one of about 0.33 to 0.83, about 0.33 to 0.60, or about 0.60 to 0.83.

With the arithmetic mean roughness, the grip feeling of the outer surface 411 of the housing 410 may be enhanced, and the impact resistance may be enhanced while maintaining the thickness of the housing 410 thin. Further, according to an embodiment, in case that the plurality of atypical rod patterns RB constitute the arithmetic mean roughness, it may be identified that the outer surface 411 of the housing 410 sparkles more irregularly.

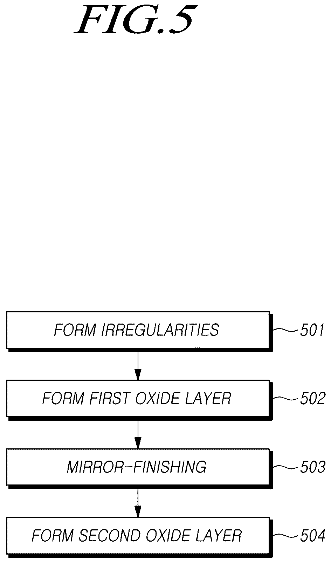

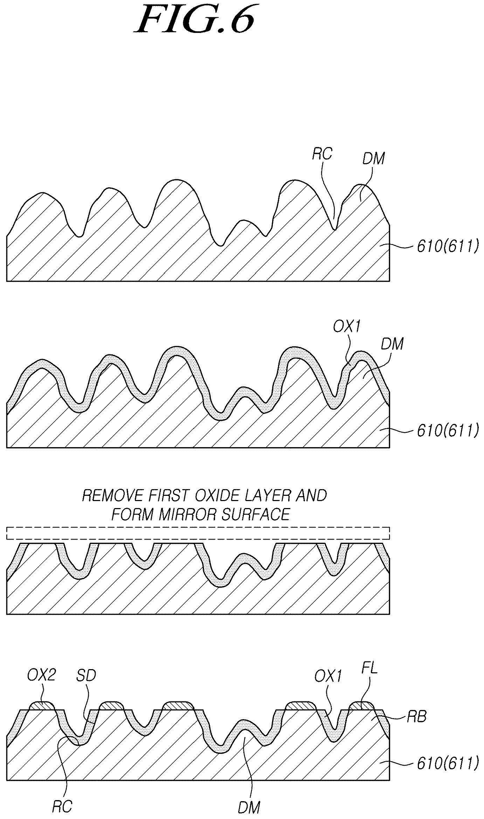

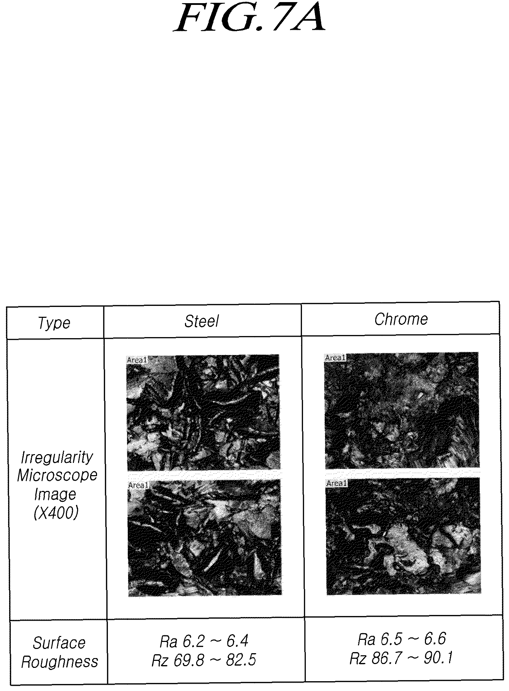

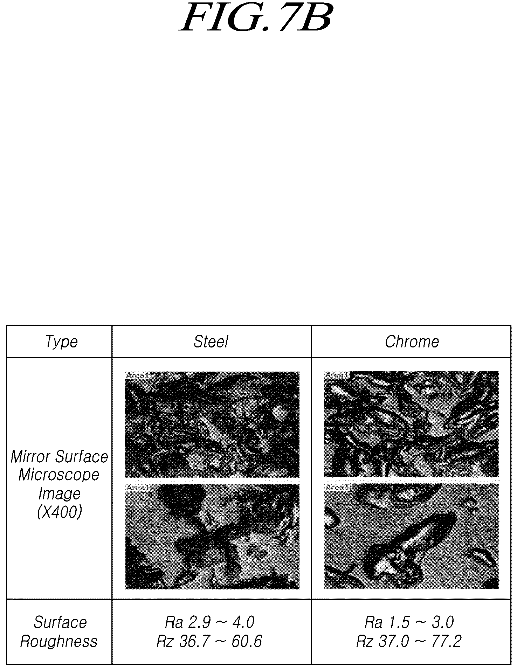

FIG. 5 is a flowchart illustrating a manufacturing method of a housing according to an embodiment of the disclosure. FIG. 6 is a diagram illustratively illustrating a cross-section of a housing according to each step of the manufacturing method of FIG. 5. FIGS. 7A and 7B are views for an experimental example in which the average roughness and average maximum height of profile of a housing change before and after mirror-finishing.

In step 501, a plurality of irregular irregularities DM may be formed on the housing 610 (or the outer surface 611 of the housing 610). A blasting process may be performed to impart an irregular form. The blasting process may be a process of physically processing the surface of the housing 610 using blasting media. The blasting media may be referred to as 'media'.

In a manufacturing method according to an embodiment, the media may be prepared with steel and/or chromium material that is angular in shape, gritty, and has a size of 2.0 mm or more. As the surface of the housing 610 is struck with media that is angular in shape, large in size, and heavy in specific gravity, a plurality of irregularities DM of irregular shapes may be formed. In this case, the depth of the irregularities DM may be formed to a value sufficiently greater than the thickness of the first oxide layer OX1. Specifically, the depth of the irregularities DM may have a dimension greater than 8 um, which is the thickness of the first oxide layer OX1, in order to provide the mirror surface FL on which the second oxide layer OX2 is formed.

Referring to FIGS. 5 and 6, a plurality of irregularities DM may be formed on the outer surface 611 of the housing 610 by the blasting process. The plurality of irregularities DM may be formed with different shapes and/or different thicknesses from each other.

Referring to FIGS. 5 and 7A, in case that the blasting process was performed on steel with the media, Ra of the plurality of irregularities DM was measured as 6.2 to 6.4 um, and Rz was measured as 69.8 to 82.5 um. In case that the blasting process was performed on chrome with the media, Ra of the plurality of irregularities DM was measured as 6.5 to 6.6 um, and Rz was measured as 86.7 to 90.1 um.

In step 502, a first oxidation treatment may be performed on the plurality of irregularities DM, and a first oxide layer OX1 may be formed on the plurality of irregularities DM by the first oxidation treatment.

According to an embodiment, the oxidation treatment may include a pretreatment process (e.g., degreasing process, cleaning process), a chemical polishing process, a desmut process, an anodizing process, a coloring process, and/or a sealing process. At least some of the processes may be omitted, and other processes may be added.

The pretreatment process may remove oil (e.g., cutting oil, polish residue, etc.) or impurities. The pretreatment process may be applied by adjusting immersion time and temperature conditions according to the characteristics and specifications of the aluminum alloy material, such as acid degreasing, alkaline degreasing, or neutral series.

The chemical polishing process may control the appearance gloss and/or fine burrs and arithmetic mean roughness using a mixed solution including phosphoric acid and sulfuric acid.

The desmut process may be performed to remove metallic impurities and/or for surface adjustment. In the desmut process, an acidic solution is used and may include, e.g., sulfuric acid or nitric acid. The concentration of the acidic solution may be adjusted to 5 to 800g/L, and the temperature may be applied at room temperature or higher. The immersion time may be treated from 5 seconds to 30 minutes according to the characteristics and specifications of the aluminum alloy material.

The anodizing process may form a porous oxide layer. In the anodizing process, sulfuric acid, oxalic acid, phosphoric acid, and/or chromic acid may be used as an electrolyte, and the applied voltage, temperature, or immersion time may be adjusted according to the purpose of the oxide layer. According to an example, the anodizing process may be performed under conditions of an electrolyte including sulfuric acid concentration of 150 to 300g/L, an ambient temperature of 0 to 30°C, a voltage of 5 to 40V, an immersion time of 10 minutes to 3 hours, and an electrolyte temperature of 5 to 30°C, but the disclosure is not limited thereto.

The coloring process may be performed after the oxide layer (e.g., the first oxide layer OX1 or the second oxide layer OX2) is formed. The coloring process may dissolve organic dye in water to immerse the material, and then color the dye. The oxide layer may have a predetermined color by the coloring process. Specifically, the oxide layer may be formed to be porous, and a specific color may be represented by adsorbing dye into a plurality of pores provided in the oxide layer. The coloring process may include, but is not limited to, an aqueous method of immersing the housing 610 on which the oxide layer is formed after dissolving the dye in water. The degree of coloring may be adjusted according to the temperature of the coloring bath (e.g., 30 to 60°C) and/or the concentration of the dye (e.g., 0.1 to 10g/L).

After the coloring process, a sealing process may be performed to seal the pores through the sealing process. The sealing process includes, but is not limited to, a metal salt treatment method, a non-metal salt treatment method, or a hydration sealing treatment method. The mixed acid used in the sealing process may be a mixed solution of phosphoric acid and sulfuric acid, but the disclosure is not limited thereto.

Referring to FIGS. 5 and 6, a first oxide layer OX1 may be formed on the plurality of irregularities DM. The first oxide layer OX1 may be formed with a substantially uniform thickness from the surfaces of the plurality of irregularities DM.

In step 503, mirror-finishing may be performed on the plurality of irregularities DM on which the first oxide layer OX1 is formed. At least a portion of the first oxide layer OX1 and at least a portion of the plurality of irregularities DM may be removed by the mirror-finishing.

In an embodiment, the mirror-finishing may be processing by a cutting tool or a grinding tool. The mirror-finishing may be performed by a polishing tool having a flat processing surface. Accordingly, the mirror surfaces FL of the atypical rod patterns RB formed by the mirror-finishing may be formed to have substantially the same slope. In an example, the polishing tool may include about 60% polyurethane, about 40% silicon carbide, and a small amount of silicon oxide, and the mirror-finishing may be performed under at least one of rough cutting conditions or finish cutting conditions. Further, the mirror-finishing may also be implemented by a sandpaper pad including an alumina component. The processing conditions of the sandpaper pad may be set to RPM, 1000, feed, 500 mm/min, depth of cut, 0.5 to 1.0mm, Mesh #800.

Referring to FIGS. 5 and 6, the first oxide layer OX1 and a portion (e.g., upper portion) of the plurality of irregularities DM may be removed and an atypical rod pattern RB may be formed. Further, by the mirror-finishing, a mirror surface FL may be formed on the upper surface of the atypical rod pattern RB. The mirror surface FL may be formed at substantially the same slope as another mirror surface FL in a specific region.

Referring to FIGS. 5 and 7B, in case that the blasting process was performed on steel with the media, Ra of the plurality of irregularities DM was measured as 2.9 to 4.0 um, and Rz was measured as 36.7 to 60.6 um. In case that the blasting process was performed on chrome with the media, Ra of the plurality of irregularities DM was measured as 1.5 to 3.0 um, and Rz was measured as 37.0 to 77.2 um.

In step 504, a second oxide layer OX2 may be formed on the mirror surfaces FL of the plurality of atypical rod patterns RB. In an example, the second oxide layer OX2 may be formed only on the plurality of mirror surfaces FL from which the first oxide layer OX1 has been removed. The second oxide layer OX2 may be formed by an oxidation treatment, and in an embodiment of the disclosure, the oxidation treatment may be divided into a first oxidation treatment for forming the first oxide layer OX1 and a second oxidation treatment for forming the second oxide layer OX2. The first oxidation treatment is the same as step 502, and the second oxidation treatment may be performed substantially identical or similar to the first oxidation treatment. However, according to an embodiment, the second oxide layer OX2 may be formed thinner than the first oxide layer OX1, and the conditions of the second oxidation treatment may be set differently from the conditions of the first oxidation treatment to form the second oxide layer OX2 thinner than the first oxide layer OX1. In case that the second oxide layer OX2 is formed thinner than the first oxide layer OX1, the reflectance at the mirror surface FL may increase, and the sparkle of the appearance of the housing 610 may be enhanced by the reflection of the mirror surface FL.

As such, the housing 610 manufactured by the manufacturing method according to an embodiment of the disclosure includes atypical rod patterns RB irregularly disposed on the outer surface 611, and the mirror surfaces FL of the atypical rod patterns RB may have a sparkling effect by reflecting incident light from the outside. As the plurality of irregularities DM serving as the basis for the atypical rod patterns RB and/or their mirror surfaces FL are formed irregularly, the sparkling effect by the mirror surfaces FL may also be represented irregularly. The irregular sparkling effect may form an appearance with excellent aesthetics like the Milky Way. Further, by forming the outer surface 611 having roughness in a specific numerical range, irritation to the skin is not significant in case of being gripped by a user, and the grip feeling may be enhanced by increasing the contact area between the skin and the housing 610. Further, impact resistance from external impacts may also be enhanced by the plurality of atypical rod patterns RB.

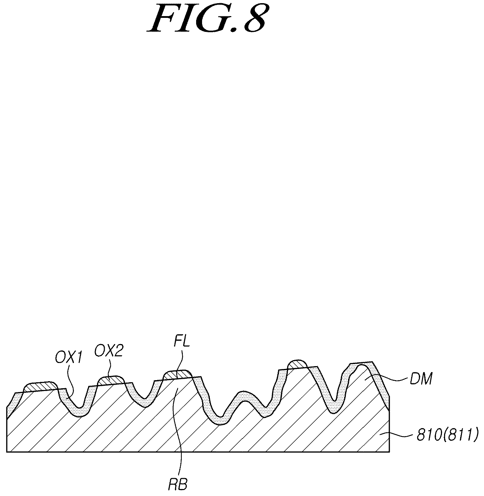

FIG. 8 is a cross-sectional view illustrating the region A of the housing illustrated in FIG. 3 according to an embodiment of the disclosure.

For convenience of description, descriptions overlapping with FIG. 4 are omitted, and the description will focus on differences. Referring to FIG. 8, the mirror-finishing of the housing 810 according to an embodiment of the disclosure may be performed at a predetermined acute angle with the horizontal direction, and accordingly, the mirror surface FL may be formed at a predetermined acute angle with respect to the horizontal direction. As such, by performing mirror-finishing at a predetermined acute angle, the amount of processing may be adjusted. Specifically, the left side of FIG. 8 may be processed relatively more, and the right side may be processed relatively less. Accordingly, the mirror surface FL of the portion with a large processing amount may have a larger area compared to the case of mirror-finishing in the horizontal direction, and the sparkling effect may be enhanced. In contrast, the mirror surface FL of the portion with a smaller processing amount may have a smaller area compared to the case of mirror-finishing in the horizontal direction, and the sparkling effect may be decreased.

As such, by forming the mirror surface FL having a predetermined acute angle, the processing amount of the mirror-finishing may be adjusted, and furthermore, by adjusting the processing amount, a gradation effect in which the degree of sparkle varies according to the position of the housing 810 may be implemented.

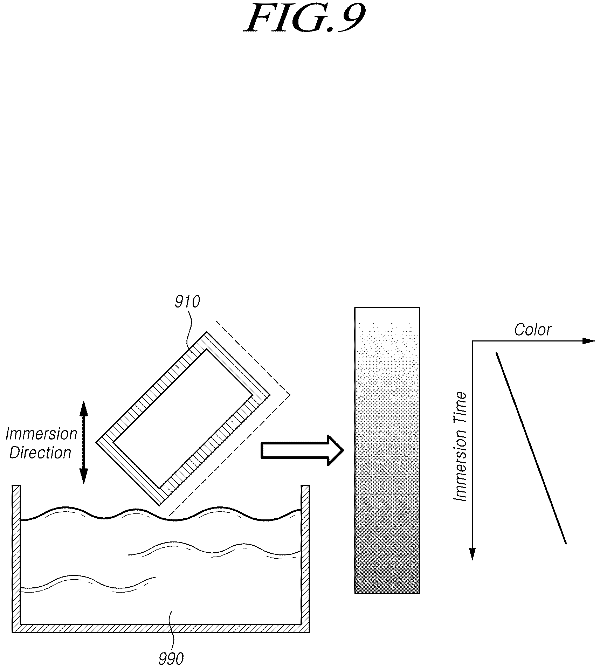

FIG. 9 is a schematic diagram illustrating a coloring process according to an embodiment of the disclosure.

Referring to FIG. 9, a coloring process according to an embodiment may be performed by immersing the housing 910 at a predetermined angle. In the coloring process, color changes may be created by adjusting the conditions of the immersion direction and immersion time. By applying this, the housing 910 may have a gradual color change by immersing it at a predetermined direction while adjusting the immersion time.

Specifically, in case that the housing 910 is immersed at a predetermined acute angle rather than immersing it in a vertical or horizontal direction, the coloring concentration varies from the initially immersed portion to the finally immersed portion, and due to such concentration difference, the housing 910 may have a gradual color change.

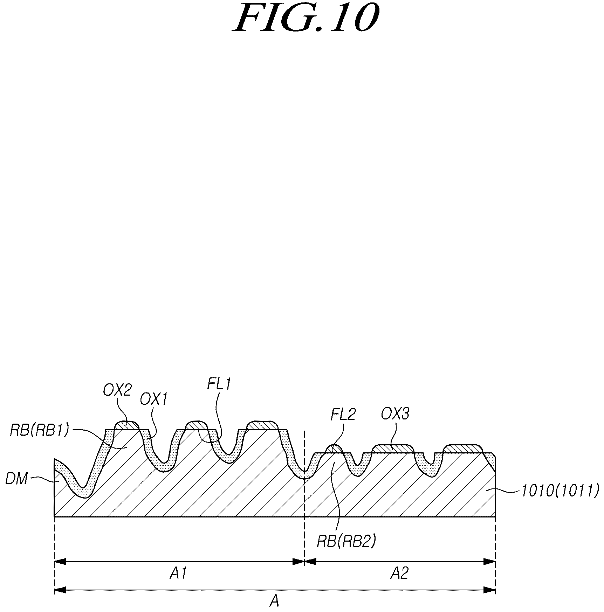

FIG. 10 is a cross-sectional view illustrating the region A of the housing illustrated in FIG. 3 according to an embodiment of the disclosure.

For convenience of description, descriptions overlapping with FIG. 4 are omitted, and the description will focus on differences. According to an embodiment, the region A may include a first sub region A1 and a second sub region A2. According to an embodiment, the housing 1010 may include atypical rod patterns RB of different shapes from each other in the first sub region A1 and the second sub region A2.

According to an embodiment, the housing 1010 may include a first atypical rod pattern RB1 in the first sub region A1 and a second atypical rod pattern RB2 in the second sub region A2. The average maximum height of profile of the first atypical rod patterns RB1 may be greater than the average maximum height of profile of the second atypical rod patterns RB2.

In an embodiment, the second atypical rod patterns RB2 may be formed by secondary mirror-finishing of the first atypical rod patterns RB1. Specifically, across the region A, the first atypical rod patterns RB1 may be formed by primary mirror-finishing, and then the second atypical rod patterns RB2 may be formed by secondary mirror-finishing only for the second sub region A2 while leaving the first sub region A1 as is. Accordingly, the second atypical rod patterns RB2 may have a smaller average maximum height of profile than the first atypical rod patterns RB1.

In an embodiment, a second oxide layer OX2 may be formed on a first mirror surface FL1 of the first atypical rod pattern RB1, and a third oxide layer OX3 may be formed on a second mirror surface FL2 of the second atypical rod pattern RB2. The third oxide layer OX3 may be formed by a third oxidation treatment. The second oxide layer OX2 and the third oxide layer OX3 may be formed with different thicknesses from each other. Separate coloring processes may be performed on the second oxide layer OX2 and the third oxide layer OX3 to have different colors from each other.

According to an embodiment, the second oxide layer OX2 that causes a sparkling effect may be disposed on the first mirror surface FL1, and the third oxide layer OX3 that prevents a sparkling effect (i.e., to be matte) may be disposed on the second mirror surface FL2. Accordingly, according to an embodiment, the appearance of the housing 1010 may be implemented with more diverse colors.

Devices according to various exemplary embodiments of the disclosure may be described as follows.

In an embodiment, an electronic device (e.g., the electronic device 101 of FIG. 1, or the electronic device 200 of FIGS. 2A and 2B) may include a housing (e.g., the housing 210 of FIGS. 2A and 2B, the housing 310 of FIG. 3, the housing 410 of FIG. 4, the housing 610 of FIG. 6, the housing 810 of FIG. 8, or the housing 1010 of FIG. 10), and the housing may include an outer surface (e.g., the outer surface 211 of FIGS. 2A and 2B, the outer surface 311 of FIG. 3, the outer surface 411 of FIG. 4, the outer surface 611 of FIG. 6, the outer surface 811 of FIG. 8, or the outer surface 1011 of FIG. 10) including an irregular surface shape. The outer surface may include a plurality of recessions RC having irregular shapes, and a plurality of atypical rod patterns RB including a plurality of mirror surfaces FL positioned adjacent to the plurality of recessions and formed horizontally with respect to each other.

In an embodiment, a first oxide layer OX1 may be disposed on the plurality of recessions.

In an embodiment, a second oxide layer OX2 may be disposed on the plurality of mirror surfaces.

In an embodiment, the first oxide layer and the second oxide layer may be formed with different thicknesses from each other.

In an embodiment, the first oxide layer may be surrounded by the second oxide layer when viewing the surface shape vertically.

In an embodiment, at least one of the first oxide layer and/or the second oxide layer may be colored to exhibit a predetermined color.

In an embodiment, the plurality of mirror surfaces may include a first mirror surface and a second mirror surface disposed around the first mirror surface. The first mirror surface and the second mirror surface may have continuous slope change values with respect to each other.

In an embodiment, the plurality of recessions and the plurality of mirror surfaces may be formed by mirror-finishing a plurality of irregularities DM.

In an embodiment, the plurality of irregularities may be formed through a blasting method using spherical or grit-shaped media such that the plurality of irregularities have an irregular surface shape.

In an embodiment, the first oxide layer may be formed on the plurality of irregularities, and the second oxide layer may be formed on the plurality of mirror surfaces after the mirror-finishing of the plurality of irregularities.

In an embodiment, a depth of the plurality of irregularities may be formed to be equal to or greater than a thickness of the first oxide layer.

In an embodiment, an arithmetic mean roughness (Ra) of the plurality of irregularities may be 6.2 to 6.4 um, or 6.5 to 6.6 um.

In an embodiment, an average maximum height of profile (Rz) of the plurality of irregularities may be 69.8 to 82.5 um, or 86.7 to 90.1 um.

In an embodiment, an arithmetic mean roughness (Ra) of the outer surface including the plurality of mirror surfaces may be 2.9 to 4.0 um, or 1.5 to 3.0 um.

In an embodiment, an average maximum height of profile of the outer surface including the plurality of mirror surfaces may have a thickness of 36.7 to 60.6 um or 37.0 to 77.2 um.

The electronic device according to various embodiments may be one of various types of electronic devices. The electronic devices may include, for example, a display device, a portable communication device (e.g., a smartphone), a computer device, a portable multimedia device, a portable medical device, a camera, a wearable device, or a home appliance. The electronic devices according to an embodiment are not limited to those described above.

It should be appreciated that various embodiments of the disclosure and the terms used therein are not intended to limit the technological features set forth herein to particular embodiments and include various changes, equivalents, or replacements for a corresponding embodiment. As used herein, the singular forms "a," "an," and "the" are intended to include the plural forms as well, unless the context clearly indicates otherwise. As used herein, the term 'and/or' should be understood as encompassing any and all possible combinations by one or more of the enumerated items. As used herein, the terms "include," "have," and "comprise" are used merely to designate the presence of the feature, component, part, or a combination thereof described herein, but use of the term does not exclude the likelihood of presence or adding one or more other features, components, parts, or combinations thereof. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order).

As used herein, the term "part" or "module" may include a unit implemented in hardware, software, or firmware, and may interchangeably be used with other terms, for example, "logic," "logic block," "part," or "circuitry". A part or module may be a single integral component, or a minimum unit or part thereof, adapted to perform one or more functions. For example, according to an embodiment, 'part' or 'module' may be implemented in a form of an application-specific integrated circuit (ASIC).

As used in various embodiments of the disclosure, the term "if" may be interpreted as "when," "upon," "in response to determining," or "in response to detecting," depending on the context. Similarly, "if A is determined" or "if A is detected" may be interpreted as "upon determining A" or "in response to determining A", or "upon detecting A" or "in response to detecting A", depending on the context.

The program executed by the electronic device described herein may be implemented as a hardware component, a software component, and/or a combination thereof. The program may be executed by any system capable of executing computer readable instructions.

The software may include computer programs, codes, instructions, or combinations of one or more thereof and may configure the processing device as it is operated as desired or may instruct the processing device independently or collectively. The software may be implemented as a computer program including instructions stored in computer-readable storage media. The computer-readable storage media may include, e.g., magnetic storage media (e.g., read-only memory (ROM), random-access memory (RAM), floppy disk, hard disk, etc.) and an optically readable media (e.g., CD-ROM or digital versatile disc (DVD). Further, the computer-readable storage media may be distributed to computer systems connected via a network, and computer-readable codes may be stored and executed in a distributed manner. The computer program may be distributed (e.g., downloaded or uploaded) via an application store (e.g., Play Store^{™}), directly between two UEs (e.g., smartphones), or online. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101, 200) comprising a housing (210, 310, 410, 610, 810, 1010), wherein the housing includes an outer surface (211, 311, 411, 611, 811, 1011) including an irregular surface shape, and wherein the outer surface includes a plurality of recessions (RC) having irregular shapes, and a plurality of atypical rod patterns (RB) including a plurality of mirror surfaces (FL) positioned adjacent to the plurality of recessions and formed horizontally with respect to each other.

2. The electronic device of claim 1, wherein a first oxide layer (OX1) is disposed on the plurality of recessions, and a second oxide layer (OX2) is disposed on the plurality of mirror surfaces.

3. The electronic device of claim 2, wherein the first oxide layer and the second oxide layer are formed with different thicknesses from each other.

4. The electronic device of claim 2 or 3, wherein the second oxide layer is surrounded by the first oxide layer when viewing the surface shape vertically.

5. The electronic device of any one of claims 2 to 4, wherein at least one of the first oxide layer or the second oxide layer is colored to exhibit a predetermined color.

6. The electronic device of any one of claims 1 to 5, wherein the plurality of mirror surfaces include a first mirror surface and a second mirror surface disposed around the first mirror surface, and the first mirror surface and the second mirror surface have continuous slope change values with respect to each other.

7. The electronic device of any one of claims 1 to 6, wherein the plurality of recessions and the plurality of mirror surfaces are formed by mirror-finishing a plurality of irregularities (DM).

8. The electronic device of claim 7, wherein the plurality of irregularities are formed through a blasting method using spherical or grit-shaped media such that the plurality of irregularities have an irregular surface shape.

9. The electronic device of claim 7 or 8, wherein the first oxide layer is formed on the plurality of irregularities, and
wherein the second oxide layer is formed on the plurality of mirror surfaces after the mirror-finishing of the plurality of irregularities.

10. The electronic device of any one of claims 7 to 9, wherein a depth of the plurality of irregularities is formed to be equal to or greater than a thickness of the first oxide layer.

11. The electronic device of any one of claims 7 to 10, wherein an arithmetic mean roughness (Ra) of the plurality of irregularities has a thickness of 6.2 to 6.4 um, or 6.5 to 6.6 um.

12. The electronic device of any one of claims 7 to 11, wherein an average maximum height of profile (Rz) of the plurality of irregularities has a thickness of 69.8 to 82.5 um, or 86.7 to 90.1 um.

13. The electronic device of any one of claims 1 to 12, wherein an arithmetic mean roughness (Ra) of the outer surface including the plurality of mirror surfaces is 2.9 to 4.0 um, or 1.5 to 3.0 um.

14. The electronic device of any one of claims 1 to 13, wherein an average maximum height of profile of the outer surface including the plurality of mirror surfaces is 36.7 to 60.6 um or 37.0 to 77.2 um.

15. A housing comprising an outer surface (211, 311, 411, 611, 811, 1011) including an irregular surface shape, wherein the outer surface includes a plurality of recessions (RC) having irregular shapes, and a plurality of atypical rod patterns (RB) including a plurality of mirror surfaces (FL) positioned adjacent to the plurality of recessions and formed horizontally with respect to each other.
